Europäisches Patentamt

European Patent Office

Office européen des brevets

(19)

(11) Publication number: **0 164 928**

A2

## (12) EUROPEAN PATENT APPLICATION

(21) Application number: 85303465.0

(22) Date of filing: 17.05.85

(51) Int. Cl.⁴: **C 23 C 16/44**
**C 30 B 25/08**

(30) Priority: 04.06.84 US 616867

(43) Date of publication of application:
18.12.85 Bulletin 85/51

(84) Designated Contracting States:
DE FR GB

(71) Applicant: TEXAS INSTRUMENTS INCORPORATED
13500 North Central Expressway
Dallas Texas 75265(US)

(72) Inventor: Massey, Robert G.
318 Chisholm Trail
Sherman, TX 75090(US)

(72) Inventor: Heidt, Donald W.
RFD 1
Sherman, TX 75090(US)

(74) Representative: Abbott, David John et al,
Abel & Imray Northumberland House 303-306 High
Holborn
London, WC1V 7LH(GB)

(54) Vertical hot wall CVD reactor.

(57) This invention relates to a method and apparatus for chemical vapor deposition of then film material layers onto a substrate. The method and apparatus can be used for epitaxially depositing silicon, for example, in the fabrication of semiconductor electronic devices. The apparatus has a multiple-substrate reactor (12), each having substrate carrier supports (14), which are rotated; and wherein the reaction gases are passed separately via interior manifolds (15, 16) into contact with each substrate carried and rotated by the supports (14). The heat source (11) is an electrical resistance-heated furnace element (11) surrounding the process chamber (12, 13), producing a "hot wall" condition, heretofore considered unacceptable for epitaxial silicon growth.

Fig. 1

Croydon Printing Company Ltd.

1

## VERTICAL HOT WALL CVD REACTOR

### BACKGROUND AND SUMMARY OF THE INVENTION

This invention relates to the chemical vapor deposition of thin film material layers on a substrate; and more particularly to a method and apparatus for carrying out such depositions, including the epitaxial deposition of silicon, for example, used in the fabrication of semiconductor electronic devices.

It has been generally accepted in the industry that semiconductor-grade monocrystalline silicon epitaxy, requires a "cold-wall" reactor design, involving the use of RF energy to generate heat in susceptors whereon silicon slices or other substrates are supported; or the use of infrared lamps to focus heat on the substrates.

The use of a "hot wall" reactor has been considered unacceptable because of the inability to suppress homogeneous gas phase reactions, and the unwanted deposition of silicon on reactor walls and other parts, followed by flaking and/or settling of such unwanted silicon in particulate form, thereby contaminating the epitaxial layers formed on the substrates.

Other considerations that weigh heavily in the development of new reactor configurations are the need for deposition thickness uniformity across individual slices, and from slice to slice, crystalline quality, and pattern

integrity.   These are affected by the gas flow pattern and flow rates, the control and uniformity of heat input, the slice carrier configuration, the deposition pressure and temperature, the composition of feed gases, and the composition of reactor parts.

## OBJECTS OF THIS INVENTION

A primary object of this invention is to provide a "hot-wall" reactor configuration that avoids or minimizes the above mentioned contamination problems, and thereby achieves high-quality epitaxial growth at greatly improved throughput efficiencies compared with previously available systems.

Other advantages of the invention include a slice per hour throughput rate that is independent of slice diameter. The system is also more readily adapted for automated loading and unloading of slices, than are prior systems.

Another object of the invention is to provide a method for the growth of electronic grade epitaxial silicon films having greater uniformity and crystal integrity, resulting from the use of an improved gas flow pattern, in combination with a simplified substrate carrier motion, and the virtual elimination of thermal gradients from slice front to back surfaces.

One aspect of the invention is embodied in a "hot wall" reactor comprising a resistance-heated furnace element surrounding a process tube or envelope wherein a rotatable substrate carrier is positioned between a gas inlet system and a gas exhaust system.

The carrier includes a plurality of substrate supporting means, for enabling the center of each substrate to be placed at a point on the axis of rotation of the

4

carrier. The gas inlet system includes a plurality of manifolds having ports for introducing gas at separate locations near the carrier, to provide each substrate with a separate gas-flow pattern.

The gas exhaust system is preferably positioned to remove gases at separate locations near the carrier, such that gases having passed in contact with one substrate are not permitted to pass in contact with another substrate. A preferred exhaust system includes a plurality of manifolds positioned near the carrier, each manifold having a plurality of exhaust ports spaced comparably with the spacing of the substrate support means of said carrier system. This arrangement further enhances the separation of the gas flow patterns from each other.

An alternate exhaust configuration consists essentially of ports in the base plate, spaced on the opposite side of the carrier from the gas inlet manifolds. Although this embodiment is slightly less desirable because of the reduced separation of gas flow patterns across each substrate, the concept of the invention is nevertheless fully illustrated.

The process tube surface, i.e. the inside reactor wall of the preferred emobdiment of the invention is made of a high purity refractory material selected for its ability to retain whatever spurious deposits may be formed thereon during operation of the reactor. For example, when silicon

is being deposited, pure silicon carbide is the preferred surface for interior reactor surfaces. This material is superior because any silicon deposited thereon remains in place, instead of flaking off to contaminate the substrates. Similarly, when depositing silicon, silicon carbide is the preferred material for construction of the substrate carrier, the gas inlet system, and the exhaust system, for the same reason.

When depositing silicon nitride, the preferred material for construction of reactor parts and interior surfaces is silicon nitride. For depositing silicon dioxide, the preferred construction material is quartz. These materials have also been found superior in their ability to prevent flaking of spurious deposits.

The method of the invention is carried out in the above-described reactor. The substrates are located on the rotatable supports, and the carrier assembly is rotated while reaction gases are passed in contact with the substrates during a "hot wall" condition resulting from the heat flow from the furnace element surrounding the process tube.

When depositing epitaxial silicon on monocrystalline substrates, the reaction gases comprise hydrogen and trichlorosilane and/or other halosilanes. The hydrogen is passed separately through one or more inlet manifolds, while

6

the halosilane is passed through one or more other inlet manifolds. Separate introduction avoids premature interaction of the gases, prior to slice contact.

BRIEF DESCRIPTION OF THE DRAWINGS

Figure 1 is a vertical cross section through the center of a preferred embodiment of the reactor of the invention.

Figure 2 is a similar cross section of a portion of the reactor, showing the gas inlet and exhaust manifolds in greater detail, including the gas flow patterns through the substrate carrier support levels.

Figure 3 is a perspective view of the interior of the reactor, showing the arrangement of inlet and exhaust manifolds surrounding the substrate carrier.

DESCRIPTION OF THE PREFERRED EMBODIMENT

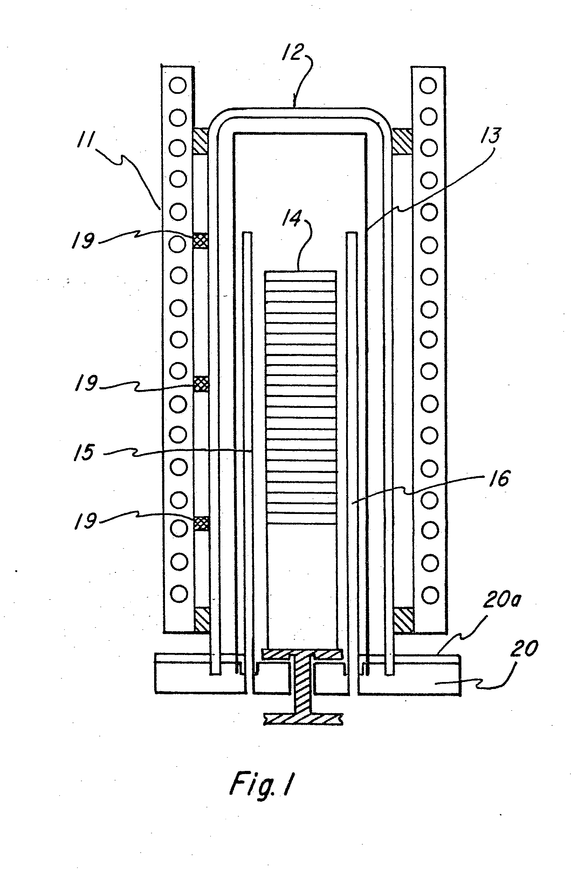

In the embodiment of Figure 1, a vertical cylindrical, resistance-heated furnace element 11 surrounds a first vertical process tube or bell jar 12, which surrounds an optional, second process tube 13, surrounding the assembly of rotatable substrate carrier support members 14 located between inlet manifolds 15 and exhaust manifolds 16. Furnace element 11 is preferably suspended from above, using a lift mechanism for elevating the furnace above the process tube or tubes, in order to provide access to the interior assembly for loading the substrates, and for facilitating maintenance.

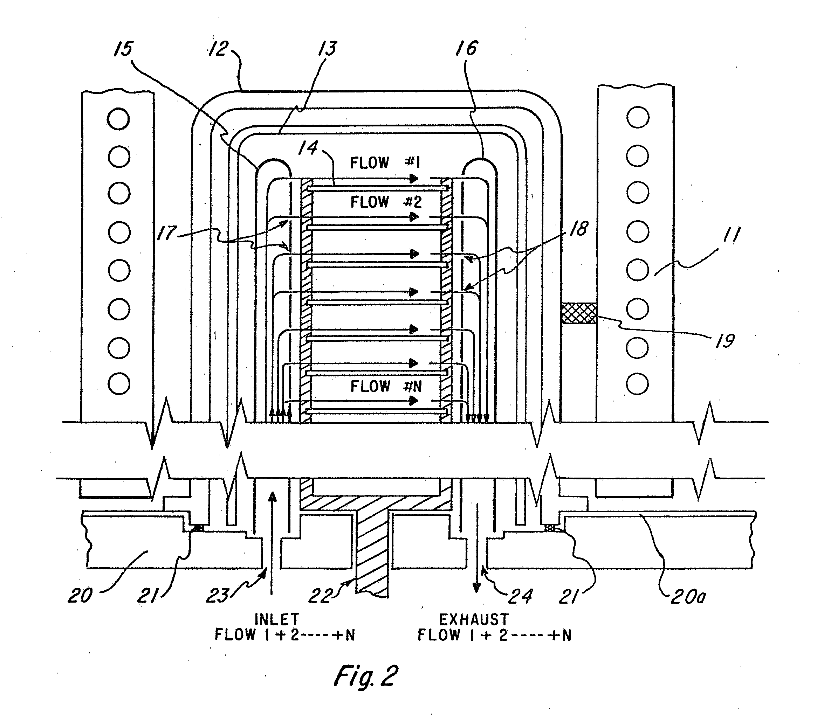

In Figure 2 the cross section of a gas inlet manifold 15 and a gas exhaust manifold 16 are shown in greater detail, including inlet ports 17 and exhaust ports 18. The size of ports 17 is progressively larger in the downstream direction of flow, in order to compensate for the pressure drop, so that equal volumes of gases flow in contact with each substrate. Conversely, the size of ports 18 is progressively smaller in the downstream direction of flow. to preserve a substantially separate flow pattern across each substrate, thermocouple 19 is used to control the furnace temperature. Baseplate 20 is fitted against the lower end of bell jar 12 with seals 21. The water-cooled base plate is isolated from reactant gases by quartz layer 20a. Substrate carrier shaft 22 extends through the baseplate 20 and is fitted with seals that permit rotation of the carrier. Gas input and exhaust are also provided through the baseplate at ports 23 and 24, respectively.

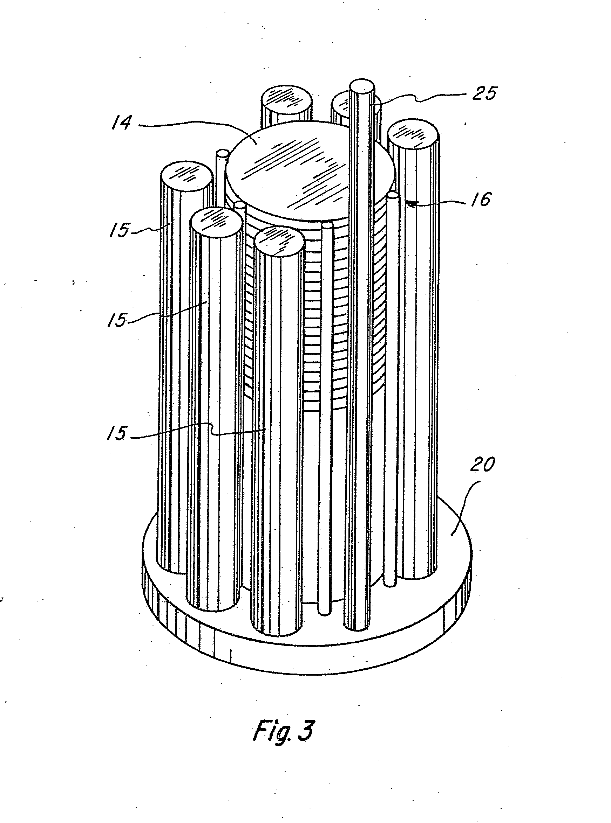

In Figure 3, the interior reactor assembly is seen to include inlet manifolds 15 partially surrounding one side of the carrier, while exhaust manifolds 16 partially surround the other side. Tube 25 is provided to house a thermocouple for temperature control.

Substrate carrier assembly 14 is removable as a unit, so that it can be readily interchangeable with other carrier

8

assemblies. This facilitates automated loading and unloading of substrates, thereby increasing reactor throughput efficiency.

Suitable reactor dimensions include a furnace element with an 11 inch inside diameter, and a 17 inch outside diameter, 60 inches long, with a 20 inch flat temperature profile zone. The process tube is 54 inches long and 8 inch inside diameter. Such a reactor size is suitable for wafers of 100 mm diameter.

A typical process sequence with predicted flow rates are as follows:

1. Load silicon wafers, furnace and bell jar in up position at 800 degrees C.

2. Lower bell jar and purge system.

3. Lower furnace element.

4. Cycle furnace up to bake/etch temperature, e.g. 1200 degrees C.

5. Bake and etch wafers while rotating carrier at about 10 revolutions per minute.

6. Cycle furnace down to deposition temperature, e.g. 1120 degrees C.

7. Purge--deposit--purge while rotating wafer support system.

8. Cycle furnace to 800 degrees C.

9. Raise furnace leaving bell jar.

10.  Cool bell jar to room temperature.

11.  Raise bell jar.

12.  Unload silicon wafers.

TYPICAL EPITAXY DEPOSITION CONDITIONS:

Hydrogen flow 0.8 to 6 liters per minute per wafer, e.g. 4 liters per minute.

Halosilane flow equal to 0.3 to 3 percent of hydrogen flow rate.

Process flows will vary as a function of wafer diameter crystal orientation of wafers, deposition temperature and deposition rate.

The composition of interior reactor walls and other interior surfaces is selected in order to prevent flaking of inadvertent deposits thereon, as previously mentioned. The primary reason that flaking is thereby prevented involves a matching of thermal expansion coefficients. That is, during thermal cycling of the reactor as a part of its routine operation, expansion and contraction of the reactor surfaces is thereby caused to equal the expansion and contraction of spurious deposits thereon, which prevents flaking.

CLAIMS

1. A vertical hot-wall reactor for the chemical vapor deposition of thin film material layers on a substrate, comprising a resistance-heated furnace element surrounding a process tube, gas-inlet means and gas exhaust means within said tube, and a rotatable substrate carrier within said tube, located between the inlet means and the exhaust means, including means for supporting a plurality of substrates such that the center of each substrate lies on the axis of rotation of said carrier.

2. A reactor as in claim 1 wherein substantially all interior surfaces and parts are made of silicon carbide.

3. A reactor as in claim 1 wherein the gas inlet means comprises a plurality of manifolds near said carrier, each of which is provided with a plurality of orifices, spaced apart so that each substrate on the carrier is provided with a separate gas input flow.

4. A reactor as in claim 1 wherein the gas exhaust means comprises a plurality of manifolds near said carrier, each of which is provided with a plurality of orifices, spaced apart so that gases are removed separately from each substrate on the carrier.

5. A method for the chemical vapor deposition of a thin film on a substrate, comprising the steps of locating the substrate on a rotatable support within a sealed chamber, surrounding the support in part with a plurality of gas inlets and in part with a plurality of exhaust ports spaced remotely from said inlets, rotating said support while passing reaction gases via said inlets in contact with the substrate, at reaction conditions, and heating said slice by a         heat source surrounding said chamber.

6.    A method as in claim 5 wherein the substrate is monocrystalline silicon, and the reaction gases comprise hydrogen and a halosilane.

7.    A method as in claim 5 wherein said         heat source is an electrical resistance-heated furnace element.

8.    A method as in claim 5 wherein a plurality of substrates is placed on a like plurality of rotatable support members, each having a common axis of rotation.

9.    A method as in claim 6 wherein the hydrogen is passed through a separate inlet manifold from said halosilane, so that mixing of the two gases is delayed until they contact the substrates.

10.    A method as in claim 5 wherein the chamber walls and parts therein are made of a material that adheres well to spurious deposits formed thereon, so as to prevent flaking.

Fig. 1

Fig.2

Fig. 3